Europäisches Patentamt

European Patent Office

Office européen des brevets

(11) Numéro de publication: **0 309 336 B1**

(12) **FASCICULE DE BREVET EUROPEEN**

(45) Date de publication de fascicule du brevet: **01.12.93** (51) Int. Cl.5: **G01R 23/02**, G01R 33/20

(21) Numéro de dépôt: **88402370.6**

(22) Date de dépôt: **20.09.88**

(54) **Procédé de mesure de la fréquence d'un signal périodique et fréquencemètre pour la mise en oeuvre du procédé.**

(30) Priorité: **21.09.87 FR 8713023**

(43) Date de publication de la demande:
**29.03.89 Bulletin 89/13**

(45) Mention de la délivrance du brevet:
**01.12.93 Bulletin 93/48**

(84) Etats contractants désignés:
**DE FR GB IT**

(56) Documents cités:
**US-A- 4 258 423**
**US-A- 4 438 504**

**E. FUKUSHIMA et al.: "EXPERIMENTAL PULSE NMR - A Nuts and Bolts Approach", 1981, pages 474-483, Addison-Wesley Publishing Company, Inc., Londres, GB**

**JOURNAL OF MAGNETIC RESONANCE, vol. 61, no. 3, 15 février 1985, pages 465-481, Academic Press, Inc., San Diego, US; H. BARKHUIJSEN et al.: "Retrieval of frequencies, amplitudes, damping factors, and phases from time-domain signals using a linear least-squares procedure"**

(73) Titulaire: **SEXTANT Avionique**
**5/7 rue Jeanne Braconnier**
**Parc Tertiaire**
**F-92368 MEUDON LA FORET Cédex(FR)**

(72) Inventeur: **Lescourret, Jean-Louis**
**10, rue Turbot**
**F-26500 Bourg les Valence(FR)**

(74) Mandataire: **Bloch, Gérard et al**
**2, square de l'Avenue du Bois**
**F-75116 Paris (FR)**

EP 0 309 336 B1

## Description

La présente invention concerne un procédé de mesure de la fréquence d'un signal périodique, en particulier sinusoïdal, ou quasi-sinusoïdal, présentant un maximum ou des maxima de puissance dans des bandes de fréquences très étroites, ainsi que le fréquencemètre pour la mise en oeuvre de ce procédé.

Il peut, par exemple, s'agir du signal délivré par une sonde à résonance magnétique nucléaire, d'une très grande sensibilité, destinée à la mesure de l'intensité du champ magnétique terrestre perturbé par des masses métalliques.

Une telle sonde est un oscillateur délivrant un signal S(t) de la forme

$$S(t) \; = \; A \sin 2\pi F_x t \; + \; B(t)$$

relation dans laquelle la fréquence $F_x$ est proportionnelle à l'intensité du champ magnétique terrestre et B(t) est le bruit.

Dans un fréquencemètre à comptage classique, après avoir mis en forme le signal S(t), pour obtenir des impulsions rectangulaires de largeur

$$T \; = \; \frac{1}{F_x} \; ,$$

et transformé, après passage dans un diviseur par D, cette série d'impulsions en une autre série d'impulsions rectangulaires de largeur DT, on compte le nombre n d'impulsions d'horloge de largeur $T_H$ pendant chaque impulsion de largeur NT, pour obtenir $F_x$ par la relation

$$F_x \; = \; \frac{D}{nT_H} \; .$$

De tels fréquencemètres peuvent être sensibles aux conditions climatiques de leur environnement, à la température, à l'humidité, etc.

Dans le domaine d'applications considéré, la précision des mesures devrait atteindre $10^{-8}$ dans le domaine spectral s'étendant sensiblement de 1000 à 3000 Hz. Si on ne veut pas altérer la bande passante nécessaire, d'environ 1 Hz, et le rapport signal sur bruit, en puissance, des signaux des sondes détectrices pouvant être notablement inférieur à 1, pareille précision ne peut pas être atteinte avec ces fréquencemètres classiques.

En présence de bruit, des effets de recouvrement des fréquences ou des battements détériorent la sensibilité des fréquencemètres classiques.

La présente invention vise à pallier les inconvénients des fréquencemètres classiques.

A cet effet, la présente invention concerne un procédé de mesure de la fréquence $F_X$ d'un signal périodique S(t) de la forme $A \sin 2\pi F_X t + B(t)$, où B(t) est le bruit, dans lequel :

- on filtre le signal S(t),
- on échantillonne, à une cadence $Fe = \frac{1}{Te}$, le signal S(t), filtré avant l'échantillonnage pour limiter le repliement des fréquences, et on numérise les échantillons,
- on filtre, dans un filtre passe-bande à bande étroite, les échantillons numérisés, pour augmenter le rapport signal sur bruit,
- on procède à une régression linéaire, à un seul coefficient a, par la méthode des moindres carrés, d'une relation linéaire, entre des échantillons numérisés successifs, de la forme

$$s_{n+2} \; + \; s_n \; = \; a \, s_{n+1}$$

avec

$$a \; = \; 2 \cos 2\pi F \, Te,$$

$s_n$ étant l'échantillon filtré de l'instant nTe,
on calcule, sur un horizon temporel d'estimation NTe et donc à une cadence $\frac{Fe}{N}$, N étant un entier

2

positif, l'estimation $\hat{\alpha}$ du coefficient a, de laquelle on tire $F_X$ (7,8) selon $F_X = \frac{Fe}{2\pi}$ arc cos $\frac{a}{2}$ , et on asservit la fréquence centrale du filtre passe-bande sur la fréquence estimée du signal échantillonné et numérisé.

Grâce à l'invention, les inconvénients de l'art antérieur sont éliminés.

Certes, US-A-4 438 504 enseigne un procédé de mesure de fréquence, mais qui s'applique exclusivement à des données numériques qui ne sont pas filtrées avant traitement.

Au contraire, le procédé de la présente demande s'applique à un signal analogique qui est filtré avant échantillonnage. Après numérisation des échantillons, ceux-ci sont filtrés dans un filtre passe-bande à bande étroite asservi sur la fréquence du signal d'entrée, au moyen de la valeur estimée $\hat{\alpha}$ de la relation linéaire entre trois échantillons numériques successifs du signal filtré et selon un système bouclé original.

En outre, le paramètre B de la relation (2a) de la colonne 3 de US-A-4 438 504 est estimé par algorithme itératif, à la cadence $\frac{1}{\Delta T}$ = Fe de l'arrivée des échantillons, comme illustré sur la figure 3 de ce document.

Au contraire, dans le procédé de la présente demande, l'identification de la relation (ou regression) linéaire entre la somme des deux échantillons numériques ($Y_n + Y_{n-2}$) et l'échantillon adjacent $Y_{n-1}$ repose sur un principe différent de celui de l'art antérieur, à la cadence $\frac{Fe}{N}$ par la méthode des moindres carrés non récursifs, sans algorithme itératif.

En d'autres termes, US-A-438 504 se borne à divulguer le filtrage des échantillons numérisés par l'intermédiaire d'un filtre numérique et le calcul de la fréquence à mesurer selon une fonction d'arc cos au moyen du calcul par ordinateur, sur un horizon temporel d'estimation, de l'estimée d'un coefficient.

Il est à noter aussi que le document Experimental Pulse NMR, Addison-Wesley Publishing Comp.Inc., 1981, pages 474-483 divulgue l'utilisation d'un filtre passe-bas pour augmenter le rapport signal sur bruit, que le document Journal of Magnetic Resonance, vol.61, No.3, 1985, pages 465-481 divulgue l'utilisation d'une regression linéaire par la méthode des moindres carrés dans le domaine d'une mesure de fréquences et que le document US-A-4 258 423 divulgue l'asservissement de la fréquence centrale d'un filtre passe-bande, tel qu'utilisé dans un détecteur numérique, à la fréquence estimée du signal d'entrée.

Quand on échantillonne à une cadence Fe inférieure à la fréquence $F_x$ à mesurer, avant échantillonnage, on filtre le signal S(t) dans un filtre passe-bande dont on asservit la fréquence centrale sur la fréquence à mesurer.

Quand on échantillonne à une cadence Fe supérieure à la fréquence $F_x$ à mesurer, avant échantillonnage, on filtre le signal S(t) dans un filtre passe-bas.

De préférence encore, on procède à ladite régression linéaire autour de la valeur moyenne des variables qu'on estime sur l'horizon temporel NTe.

Avantageusement, on filtre les échantillons du signal dans un filtre passe-bande de fonction

$$s_{n+2} = (\lambda \hat{\alpha}^{\equiv})s_{n+1} - \lambda^2 s_n + \gamma S_{n+2}$$

dans laquelle :

$\lambda$      est une constante représentative de l'amortissement et de la largeur du filtre à - 3 dB,

$\hat{\alpha}^{\equiv}$      est la valeur de l'estimée du coefficient a filtrée par un filtre passe-bas, pour lisser la valeur du paramètre fixant le centre du filtre passe-bande,

$\gamma$      est une constante de cadrage fixant le gain statique du filtre passe-bande,

$s_n$      est l'échantillon filtré de l'instant nTe,

$S_{n+2}$      est l'échantillon non filtré de l'instant (n + 2)Te.

De préférence encore, on sous-échantillonne et on détermine la fréquence $F_x$ à une cadence plus faible que pour le coefficient a.

De préférence encore, pour déterminer la valeur du coefficient a, à une cadence fixe, on désynchronise la cadence de calcul du coefficient a à une fréquence prédéterminée par un filtre interpolateur ou extrapolateur.

Quand la fréquence d'échantillonnage Fe est inférieure au double de la fréquence à mesurer $F_x$, on détermine celle-ci en ajoutant à la valeur calculée de la fréquence apparente Fa le produit de la valeur de la fréquence d'échantillonnage Fe et d'un nombre entier M.

Pour initialiser le procédé, on calcule les estimées du coefficient a et de la fréquence à mesurer $F_x$ sur quelques secondes et on adopte la valeur moyenne de l'estimée de la fréquence $F_x$ comme valeur initiale.

L'invention concerne également un fréquencemètre pour la mise en oeuvre du procédé de mesure de fréquence de l'invention, caractérisé par le fait qu'il comporte, en série, un filtre analogique anti-repliement, un dispositif d'échantillonnage et de conversion analogique-numérique, un filtre passe-bande numérique asservi et une unité de calcul agencée pour procéder à une régression linéaire, à un seul coefficient a, de la relation linéaire entre des échantillons numérisés successifs fournis par le dispositif d'échantillonnage et de conversion, et calculer l'estimation du coefficient a de laquelle est tirée la fréquence à mesurer, la fréquence centrale du filtre passe-bande numérique étant asservie sur la fréquence estimée du dispositif d'échantillonnage et de conversion.

Avantageusement, le filtre analogique anti-repliement comporte au moins un filtre passe-bande à commutation de capacités, recevant un signal de commutation d'un premier diviseur programmable relié à la sortie d'une horloge de référence et commandé par l'unité de calcul.

De préférence, le filtre analogique anti-repliement comporte de plus au moins un filtre passe-bas de lissage.

De préférence, le dispositif d'échantillonnage et de conversion reçoit un signal d'échantillonnage d'un second diviseur programmable relié à la sortie de l'horloge de référence et commandé par l'unité de calcul.

L'unité de calcul commande les diviseurs programmables par l'intermédiaire d'un module de calcul des fréquences de commutation et d'échantillonnage et d'une unité de surveillance de ces fréquences.

Une unité d'initialisation peut être reliée à l'entrée du module de calcul des fréquences de commutation et d'échantillonnage.

Le filtre numérique asservi est de préférence contrôlé par l'unité de calcul par l'intermédiaire d'un filtre passe-bas numérique.

L'invention sera mieux comprise à l'aide de la description suivante du fréquencemètre de l'invention et de son fonctionnement, en référence aux dessins annexés, sur lesquels :

- la figure 1 est une représentation schématique par blocs du fréquencemètre de l'invention;
- la figure 2 est une représentation de l'échantillonneur-bloqueur-convertisseur;
- la figure 3 est une représentation du filtre analogique anti-repliement;
- la figure 4 est une représentation d'un des filtres analogiques passe-bande à commutation de capacités du filtre de la figure 3;
- la figure 5 est une représentation du premier filtre analogique passe-bas de lissage du filtre de la figure 3;
- la figure 6 est une représentation du second filtre analogique passe-bas de lissage du filtre de la figure 3;
- la figure 7 est une représentation du diviseur programmable fournissant la fréquence d'échantillonnage, et
- la figure 8 est une représentation du diviseur programmable fournissant la fréquence de commutation des filtres à commutation de capacités du filtre de la figure 3.

Le fréquencemètre qui va maintenant être décrit vise à déterminer la fréquence $F_x$ d'un signal analogique périodique S(t).

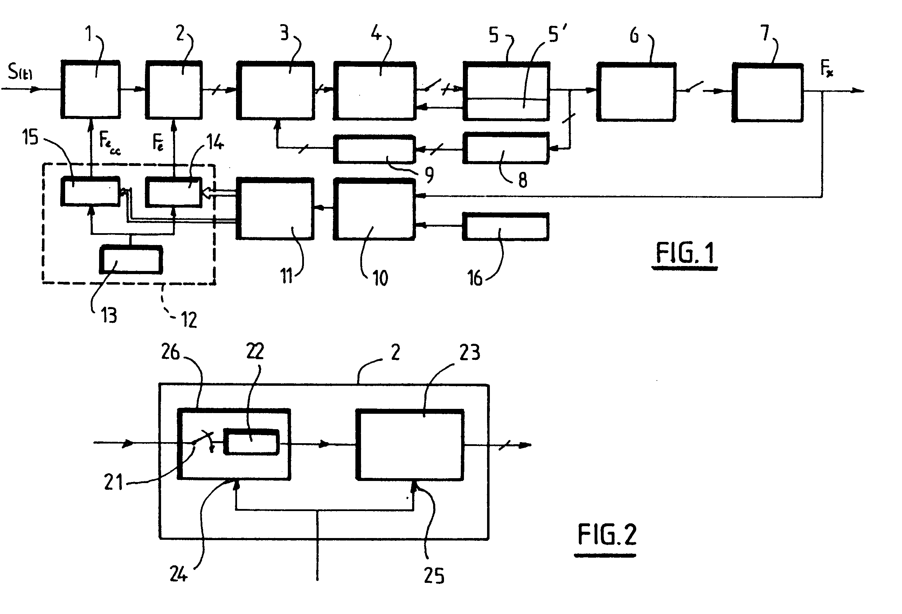

En référence à la figure 1, qui en est une représentation schématique par blocs, le fréquencemètre comprend, en série, un filtre analogique anti-repliement 1, qui reçoit sur son entrée le signal analogique S-(t), un dispositif 2 d'échantillonnage-blocage et de conversion analogique-numérique, un filtre passe-bande numérique asservi 3, à bande très étroite, une unité de calcul 4, une unité 5 de calcul de $\hat{\alpha}_K$, qui sera définie ci-après, l'unité 5 étant bouclée sur le filtre numérique passe-bande 3 par un filtre numérique passe-bas de lissage 8 et une unité de calcul 9, une unité de filtrage et de sous-échantillonnage 6, et une unité de calcul de la fréquence 7. La sortie de l'unité de calcul 7 est reliée à l'entrée d'une unité, ou module, 10 de calcul de Fe et $Fe_{Fcc}$, qui commande une unité 11 de surveillance de ces fréquences, qui, à son tour, commande deux diviseurs programmables 14 et 15, fournissant Fe et $Fe_{Fcc}$, respectivement, et branchés à la sortie d'une horloge de référence 13, les diviseurs 14, 15 et l'horloge 13 formant l'unité 12 délivrant les fréquences Fe et $Fe_{Fcc}$. Une unité d'initialisation 16 est raccordée à l'entrée de l'unité de calcul 10.

En référence à la figure 2, le signal analogique S(t) filtré dans le filtre 1 est échantillonné dans le temps en 21 à une cadence, ajustable, $Fe = \frac{1}{Te}$ et la valeur de chaque échantillon est bloquée en 22 jusqu'à l'instant d'échantillonnage suivant dans l'échantillonneur-bloqueur 26 qui reçoit en 24 le signal d'échantillonnage à fréquence Fe. L'échantillonneur-bloqueur est par exemple du type LF 198 A de la Société National Semiconductor. Les échantillons analogiques sortant de l'échantillonneur-bloqueur 26 sont convertis en numérique, ici sur 12 à 14 bits, de préférence sur 14 bits, dans le convertisseur analogique-numérique 23, par exemple du type ADC 71 de la Société Burr-Brown, qui reçoit en 25 le signal d'échantillonnage à fréquence Fe, dont on verra plus loin comment il est élaboré.

A la sortie du dispositif 2, le signal analogique S(t) est devenu une série temporelle discrète d'échantillons numérisés S(nTe) qu'on écrira par la suite Sn.

Avant échantillonnage, le signal analogique S(t) a été filtré dans le filtre 1, qui, ici, est un filtre passe-bande à commutation de capacités (FCC).

4

D'après le théorème de Shannon, sur l'échantillonnage, la largeur de bande du bruit autour de la raie spectrale correspondant au signal sinusoïdal (périodique) doit être égale ou inférieure à la fréquence d'échantillonnage, faute de quoi l'estimation, dont il sera question ci-après, est dégradée par repliement des fréquences. On notera qu'il est ici préféré d'utiliser un filtre passe-bande plutôt qu'un filtre passe-bas et d'appliquer ainsi le théorème de Shannon à la largeur de bande du filtre passe-bande plutôt qu'à la fréquence de coupure du filtre passe-bas, ce qui permet de diminuer la fréquence d'échantillonnage et de la rendre inférieure à la fréquence à mesurer. Comme on ne dispose pas de filtre idéal, on adopte une fréquence d'échantillonnage légèrement plus grande, quitte à tolérer un léger effet de recouvrement de fréquences, mais c'est le meilleur compromis.

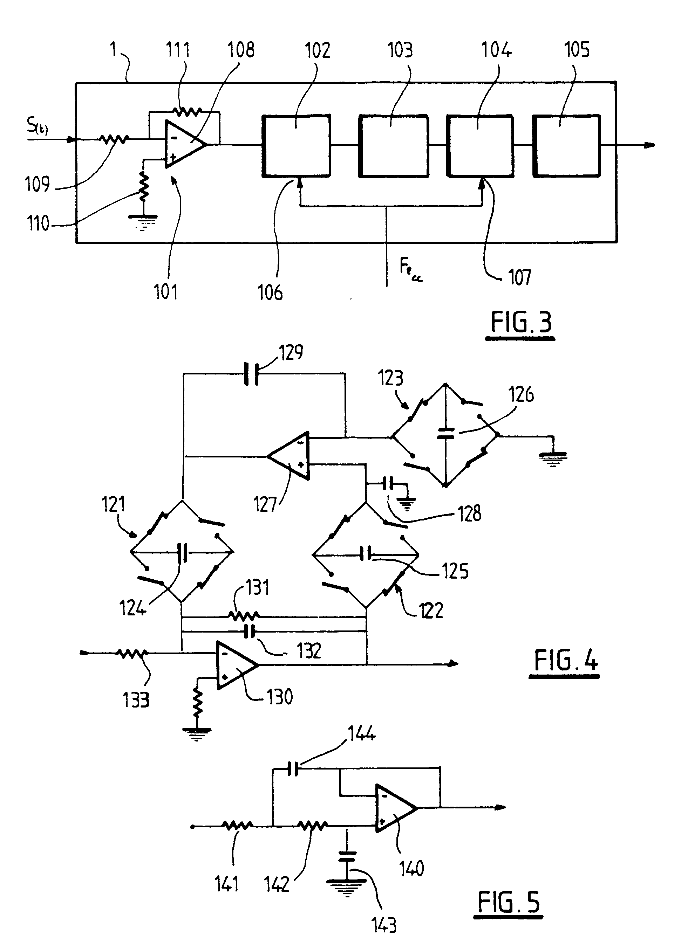

En référence à la figure 3, le filtre analogique 1 comprend en fait, en série, un étage d'entrée 101, un premier filtre passe-bande à commutation de capacités 102, un premier filtre passe-bas d'ordre 2 de lissage 103, un deuxième filtre passe-bande à commutation de capacités 104, et un deuxième filtre passe-bas d'ordre 2 de lissage 105, les filtres passe-bande 102 et 104 recevant en 106, 107 le signal de commutation à fréquence $Fe_{Fcc}$, dont on verra plus loin comment il est élaboré.

L'étage d'entrée 101, est un étage amplificateur comprenant un amplificateur opérationnel 108 recevant, sur son entrée négative et à travers une résistance 109, le signal S(t), l'entrée positive de l'amplificateur 108 étant mise à la terre par une résistance 110 de valeur moitié de celle de la résistance 109. L'entrée positive et la sortie de l'amplificateur sont réunies par une résistance 111 de même valeur que la résistance 109.

La structure des filtres analogiques passe-bande à commutation de capacités 102, 104 est précisée sur le schéma de la figure 4. Elle comporte trois ponts 121, 122, 123, chacun de quatre commutateurs analogiques, par exemple du type DG 201 A de la Société Siliconix, dans l'une des diagonales desquels est inséré un condensateur 124, 125, 126, respectivement, de même capacité $C_1$. Les commutateurs de chaque pont sont associés par paires de deux commutateurs opposés et dans le même état, dont l'ouverture pendant une portion $\phi_o$ de la période

$$\frac{1}{Fe_{Fcc}}$$

et la fermeture pendant l'autre portion $\phi_1$ de la période de commutation sont commandés en alternance par le signal de commutation, comme illustré sur la figure 4. Les trois ponts 121, 122, 123 sont respectivement reliés, par l'une des deux bornes, non reliées au condensateur du pont, communes à deux commutateurs adjacents, à la sortie, à l'entrée positive, et à l'entrée négative d'un amplificateur opérationnel 127, dont l'entrée positive est mise à la masse par un condensateur 128 de capacité C et dont l'entrée négative et la sortie sont réunies par un condensateur 129 de capacité C aussi. Les deux autres des deux dites bornes des ponts 121, 122 sont reliées respectivement à l'entrée négative et à la sortie d'un autre amplificateur opérationnel 130, en parallèle sur une résistance 131 de valeur $R_1$ et un condensateur 132 de capacité C, l'entrée positive de l'amplificateur 130 étant mise à la masse. L'entrée du filtre 102, 104 est reliée à l'entrée négative de l'amplificateur 130 par une résistance 133 de valeur $R_1$, la sortie de l'amplificateur 130 constituant la sortie du filtre. L'autre des deux bornes, non reliées au condensateur, du pont 123 est reliée à la masse. La fréquence centrale fo de ces filtres 102, 104 est donnée par la relation

$$fo = \frac{2Fe_{Fcc}}{\pi} \times \frac{C_1}{C} \quad ,$$

la largeur du filtre à - 3 dB par la relation

$$\Delta f = \frac{1}{2\pi R_1 C} \quad ,$$

le gain du filtre étant égal à 1 pour la fréquence centrale.

La formule donnant la valeur de la raie centrale peut, par exemple, être tirée de Switched-Capacitor Filter Design Using the biliwear Z-transform, GABOR C. TEMES et al., IEEE Transactions on Circuits and Systems, Vol. cas. 25 n° 12, december 1978.

La relation donnant fo peut aussi s'écrire

$$fo = \frac{1}{\beta} Fe_{Fcc}$$

soit

$$\begin{cases} Fe_{Fcc} = \beta \, fo \\ \\ \beta = \frac{\pi}{2} \times \frac{C}{C_1} \end{cases}$$

On peut adopter, pour $\beta$, une valeur de quelques unités à plusieurs centaines. Dans la pratique, on choisira une valeur de

$$\frac{C}{C_1}$$

pas trop élevée. Mais comme la distorsion associée à la fonction de transfert du filtre diminue quand $\beta$ augmente, il faut adopter un compromis.

Par ailleurs, plus $\Delta f$ est grand et moins il est nécessaire de modifier la fréquence de commutation $Fe_{Fcc}$ d'un domaine de $F_x$ à un autre. Mais plus $\Delta f$ est petit et moins l'effet de recouvrement de fréquences, lors de l'échantillonnage subséquent, se fait sentir.

En fait, il faut modifier la fréquence de commutation $Fe_{Fcc}$ quand la différence $|F_x - f_o|$ devient voisine de $\frac{\Delta f}{2}$.

A titre purement indicatif, on notera que dans la forme de réalisation effective, il a été adopté

$C = 0,1 \mu F$
$C_1 = 3,92 \mu F$
$R_1 = 14$ ou $24,3$ kΩ
$\beta = 40,07$

$R_1$ étant choisie de préférence dans la plage [14 kΩ — 61,9 kΩ] selon la valeur de $\Delta f$ désirée.

La structure du premier filtre passe-bas d'ordre 2 de lissage 103 est précisée sur le schéma de la figure 5. Elle comporte un amplificateur opérationnel 140 dont l'entrée positive, mise à la terre par un condensateur 143 de capacité $C_2$ est reliée à l'entrée du filtre par deux résistances 141, 142 en série, de même valeur $R_2$, l'entrée négative de l'amplificateur 140 étant reliée, d'une part, au point commun aux deux résistances 141, 142 par un condensateur 144 de capacité $C_3$, et, d'autre part, à la sortie de l'amplificateur.

La fréquence de coupure $f_c$ de ce filtre est donnée par la relation

$$f_{c_1} = \frac{1}{2 \pi R_2 \sqrt{C_2 C_3}}$$

Le gain du filtre 103 est égal à 1.

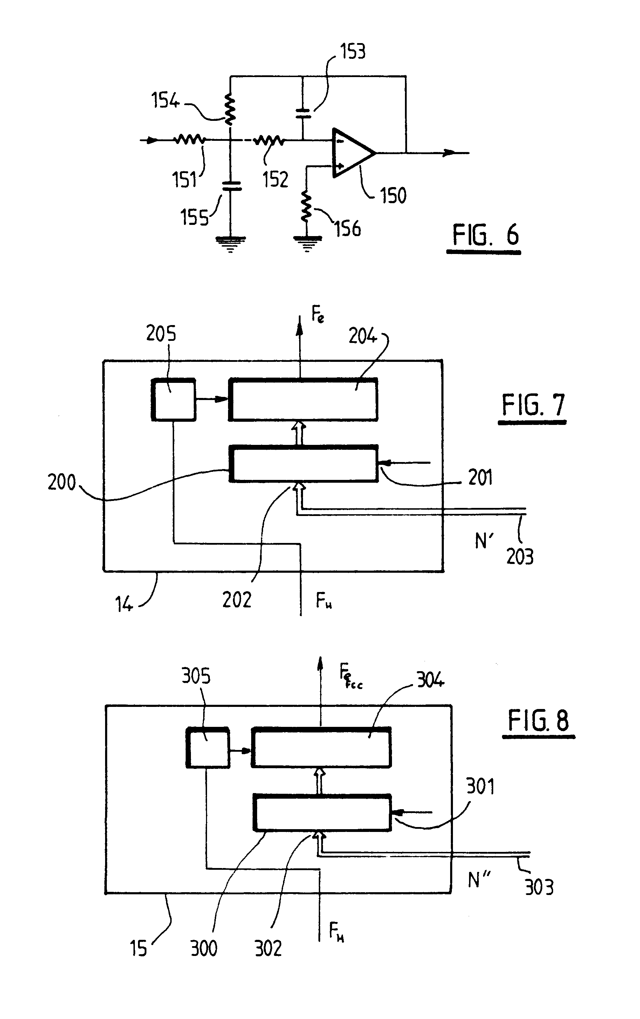

La structure du second filtre passe-bas d'ordre 2 de lissage 105 est précisée sur le schéma de la figure 6. Elle comporte un amplificateur opérationnel 150 dont l'entrée négative est reliée à l'entrée du filtre par deux résistances 151, 152 de valeurs respectives $R_3$, $R_4$, l'entrée positive de l'amplificateur étant mise à la terre par une résistance 156 de valeur $R_5$, et la sortie de l'amplificateur 150 étant reliée à son entrée négative par un condensateur 153 de capacité $C_4$ relié par ailleurs, par une résistance 154 de valeur $R_6$, au point commun aux deux résistances 151, 152, mis à la terre par un condensateur 155 de capacité $C_5$.

La fréquence de coupure

$$f_{c_2}$$

de ce filtre est donnée par la relation

$$f_{c_2} = \frac{1}{2\pi\sqrt{R_4 R_6 C_4 C_5}}$$

Le gain du filtre 105 est égal à

$$\frac{R_6}{R_3}.$$

Dans la forme de réalisation effective, on a adopté

$$f_{c_1} = f_{c_2} = 4,3 \text{ kHz}.$$

Pour revenir aux échantillons numérisés du signal S(t) filtrés, fournis par le convertisseur 23, puis filtrés par le filtre numérique asservi 3 de la figure 1, appelés $s_n$, par définition de la transformée en Z d'un signal sinusoïdal, telle qu'elle est notamment donnée dans "Systèmes et asservissements échantillonnés de Y. Sévely, Editions DUNOD, 1973", on peut considérer la suite desdits échantillons comme la réponse à une impulsion à l'origine des temps d'un filtre en Z, de fonction de transfert F(Z)

$$F(Z) = \frac{\int(Z)}{\xi(Z)} = \frac{\sin(2\pi F_a T_e) \times Z}{Z^2 - aZ + 1}$$

relation dans laquelle
- $\xi(Z)$ et $\epsilon(Z)$ sont respectivement les transformées en Z de la sortie et de l'entrée du filtre, avec ici $\xi(Z)$ = 1 puisque par hypothèse l'entrée est une impulsion unitaire à l'origine des temps,
- a = 2 cos($2\pi F_a T_e$), où Fa est défini de la façon suivante

Fa = |(Fx - M. Fe)|

où M est un entier positif tel que Fa soit compris entre 0 et Fe/2.
En effet, on a la relation

cos($2\pi F_a T_e$) = cos($2\pi$(FxTe-M)).

Cette indétermination est levée si M est déterminée par la connaissance approximative de Fx, ce qui peut être obtenu en phase d'initialisation du procédé, par exemple en choisissant lors de ladite phase une cadence d'échantillonnage Fe > 2 Fx.
Par la suite, on parlera indistinctement de $F_a$ ou de $F_x$ sachant que si Fe < 2Fx, on doit lire Fa; la valeur réelle Fx s'en déduit connaissant M.

. $Z = \exp(2\pi j\nu T_e)$ où $j = \sqrt{-1}$,

$\nu$ étant la fréquence de Fourier

On peut donc écrire, par définition

$$S(Z) = \frac{\sin(2\pi F_x T_e) \times Z\,\zeta(Z)}{Z^2 - aZ + 1} = \sum_{n=o}^{\infty} s_n \, Z^{-n}$$

où $s_n$ est ledit échantillon représentant la valeur de l'amplitude du signal sinusoïdal $\sin(2\pi F_x t)$ à l'instant $t = n\, T_e$.

Par application des théorèmes classiques démontrés dans l'ouvrage ci-dessus, on peut écrire les expressions suivantes :

$\zeta(Z) [Z^2 - a Z + 1] = Z\xi(Z) \sin(2\pi F_x T_e)$

où

$\xi(Z) = 1 = Z^o$

expression qui, écrite dans le domaine temporel, donne :

$s_{n+2} - a\, s_{n+1} + 1 = \sin(2\pi F_x T_e) \cdot e_{n+1}$

Comme par hypothèse, $e_{n+1}$ est toujours nul sauf pour $n = o$ (impulsion au temps 0) pour lequel

$s_2 = e_1 \sin(2\pi F_x T_e)$

$s_1 = s_o = 0,$

on peut écrire, pour $n \geq 1$ et pour trois échantillons consécutifs du signal sinusoïdal

$s_{n+2} - a\, s_{n+1} + s_n = 0,$

L'information "fréquence" du signal échantillonné étant contenu dans le terme $a = 2\cos 2\pi F_x Te$.

Si on pose

$y_n = s_{n+2} + s_n$

$x_n = s_{n+1}\,,$

l'équation ci-dessus s'écrit

$y_n = a\, x_n$

Avec cette dernière équation, on peut déjà rechercher des estimateurs de a, puis calculer la valeur de la fréquence $F_x$ par la relation

$$F_x = \frac{1}{2\pi Te} \,\text{arc}\,\cos\,\frac{a}{2}$$

Comme estimateurs $\hat{\alpha}$, on peut considérer

$$\hat{a} = \frac{\sum\limits_{n=1}^{N} y_n}{\sum\limits_{n=1}^{N} x_n}$$

ou

$$\hat{a} = \frac{\sigma_y}{\sigma_x} = \left[ \frac{\sum\limits_{n=1}^{N} \left(y_n - \frac{1}{N} \sum\limits_{n=1}^{N} y_n\right)^2}{\sum\limits_{n=1}^{N} \left(x_n - \frac{1}{N} \sum\limits_{n=1}^{N} x_n\right)^2} \right]^{1/2}$$

Toutefois, et dans la pratique, ces valeurs sont entachées d'erreur à cause du bruit superposé au signal, et, en particulier, la composante continue, après numérisation dans le convertisseur, affecte le premier estimateur ci-dessus et une valeur de N non multiple de

$$\frac{Fe}{F_x}$$

affecte les deux estimateurs. Le deuxième estimateur ci-dessus est néanmoins préféré, pour l'initialisation de la mesure de fréquence, à la mise sous tension par exemple, initialisation qui sera abordée plus loin.

Dans le cas général, l'équation à une seule inconnue a, $y_n = ax_n$, est avantageusement résolue par régression linéaire de la relation linéaire ci-dessus par la méthode des moindres carrés. En d'autres termes, et par la méthode des moindres carrés, on identifie a de cette relation linéaire considérée comme une régression linéaire de $y_n$ en $x_n$.

Il est utile de procéder à cette estimation autour de la valeur moyenne des variables, pour éliminer la valeur continue du signal ainsi d'ailleurs qu'une erreur d'estimation, très néfaste, due au fait que l'estimation ne peut pas s'effectuer sur une période infinie ni, en général, sur un nombre entier de périodes du signal.

Comme formule d'estimation, on considère

$$\hat{a} = \frac{E\left\{ [y_n - E(y_n)] \ [x_n - E(x_n)] \right\}}{E\left\{ [x_n - E(x_n)]^2 \right\}}$$

E représentant l'espérance mathématique, qui, de façon approchée, peut s'écrire, pour N suffisamment grand,

$$E(X) \underset{=}{\sim} \frac{1}{N} \sum_{i=1}^{N} X_{i+K} = XM_K.$$

Dans ces conditions, $E(x_n)$ et $E(y_n)$ sont les valeurs moyennes de $x_n$ et $y_n$ estimées sur l'horizon temporel de durée $NTe$ et seront écrites $XM_K$ et $YM_K$, l'indice K repérant l'horizon courant.

$E[x_n - E(x_n)]^2$ est le moment centré d'ordre 2, ou variance, de la variable $x_n$ estimée sur l'horizon $NTe$.

$E\{[y_n - E(y_n)][x_n - E(x_n)]\}$ est le moment composé, ou covariance des variables centrées $x_n$ et $y_n$ estimées sur le même horizon temporel $NTe$.

Si on pose

$$C_{xx_K} = \sum_{n=1}^{N} x_{n+K}^2$$

$$C_{xy_K} = \sum_{n=1}^{N} x_{n+K}\, y_{n+K}$$

la valeur estimée de a peut s'écrire

$$\hat{a}_K = \frac{C_{xy_K} - \dfrac{XM_x\, YM_K}{N}}{C_{xx_K} - \dfrac{(XM_K)^2}{N}}$$

Cette relation peut être encore modifiée pour tenir compte du bruit additionnel superposé au signal et qui peut fausser l'estimation $\hat{\alpha}$, notamment si le bruit sur $y_n$ n'est pas blanc et s'il est corrélé avec $x_n$ :

$$\hat{a}_K = \frac{C_{yz_K} - \dfrac{YM_K\, ZM_K}{N}}{C_{xz_K} - \dfrac{XM_K\, ZM_K}{N}}$$

l'indice z correspondant à la variable $z_n$ correlée avec $x_n$, mais dont le bruit n'est correlé ni avec le bruit sur $x_n$ ni avec le bruit sur $y_n$.

$z_n$ peut donc être choisie comme suit :

$$z_n = x_{n-M}.$$

En variante, et même de façon préférée, pour minimiser les erreurs d'estimation dues au bruit sur le signal échantillonné, on filtre le signal numérisé délivré par le convertisseur 23 par le filtre numérique passe-bande 3 à bande très étroite. Le filtre 3 élimine la composante continue et permet d'obtenir un signal sinusoïdal avec très peu de bruit qui n'impose plus la dernière estimation ci-dessus.

Si $b_n$ est le bruit à l'instant n Te sur l'échantillon $s_n$, on peut poser

$$\begin{cases} y_n = s_{n+2} + s_n + b_{n+2} + b_n \\[2mm] = y_n^* + b_{yn} \\[2mm] x_n = s_{n+1} + b_{n+1} \\[2mm] = x_n^* + b_{xn} \\[2mm] x_n^* \text{ et } y_n^* \end{cases}$$

représentant les valeurs non bruitées.

Dans ces conditions, la relation

$$\hat{a} = \frac{E\left\{[y_n - E(y_n)]\ [x_n - E(x_n)]\right\}}{E[x_n - E(x_n)]^2}$$

peut s'écrire, en supposant que les moyennes du bruit et du signal soient nulles

$$\hat{a} = \frac{E(y_n^* x_n^*) + E(x_n^* b_{yn}) + E(y_n^* b_{xn}) + E(b_{yn} b_{xn})}{E(x_n^*)^2 + E(b_{xn})^2 + E(x_n^2 b_{xn})}$$

Si on admet que le bruit est blanc, on a

$E(b_{yn}\, b_{xn}) = 0$

et que le bruit n'est pas corrélé avec le signal, on a

$E(x_n^* b_{xn}) = 0$
$E(y_n^* b_{xn}) = 0$
$E(x_n^* b_{yn}) = 0.$

Alors, on peut écrire

$$\hat{a} = \frac{E(x_n^* y_n^*)}{E(x_n^*)^2 + \sqrt{\sigma_x^2}}$$

$\sigma_x^2$ étant la variance du bruit blanc additionnel sur le signal.

L'estimée de a est donc faussée par la variance du bruit et peut s'écrire

$$\hat{a} = \hat{a}^{\Xi} \left(1 - \frac{\sigma_x^2}{E^2}\right)$$

relation dans laquelle $E^2$ est la variance du signal et

$$\frac{\sigma_x^2}{E^2}$$

est l'inverse du rapport signal sur bruit.

La fonction du filtre numérique 3 est donc de diminuer la variance du bruit additionnel, pour que le rapport signal sur bruit soit très supérieur à 1 (on peut obtenir un rapport supérieur à 1500 avec un oscillateur nucléaire), et de pouvoir utiliser la formule

$$\hat{a}_K = \frac{C_{xy_K} - \dfrac{XM_K \, YM_K}{N}}{C_{xx_K} - \dfrac{XM_K^2}{N}}$$

pour obtenir une estimation très faiblement biaisée de $a_K$ à une cadence N fois plus faible que la cadence d'échantillonnage Fe.

La mise en oeuvre de la formule ci-dessus est en outre une opération de sous-échantillonnage. L'application du théorème de Shannon sur l'échantillonnage, impose, comme on l'a déjà vu, que la largeur de bande du bruit, autour de la raie spectrale correspondant au signal sinusoïdal, soit inférieure à la fréquence d'échantillonnage, sous peine de dégrader l'estimation par repliement des fréquences. En l'espèce, la fréquence de calcul de a est $\frac{Fe}{N}$. La largeur du filtre passe-bande numérique 3 doit donc être une fraction de $\frac{Fe}{N}$ pour que le repliement soit faible.

La fonction du filtre 3, asservi sur la fréquence du signal, est de la forme

$$s_{n+2} = (\lambda \hat{a}_K^{\Xi}) \, s_{n+1} - \lambda^2 s_n + \gamma S_{n+2}$$

relation dans laquelle

. $\lambda$ est une constante représentative de l'amortissement et de la largeur du filtre à -3dB,
. $a_K^{\Xi}$ est la valeur de $a_K$ filtrée par un filtre passe-bas, par exemple du premier ordre, afin de lisser la valeur du paramètre fixant le centre du filtre passe-bande,
. $s_n$ est l'échantillon filtré à la sortie du filtre passe-bande à l'instant nTe,
. $\gamma$ est une constante de cadrage fixant le gain statique du filtre, pouvant être égal à 1.
. $S_{n+2}$ est l'échantillon non filtré, sortant de l'échantillonneur 2 à l'instant (n+2) Te.

Le procédé de mesure de fréquence, tel que décrit jusqu'ici, consiste donc à

- filtrer le signal périodique analogique S(t), à fréquence $F_x$, dans le filtre analogique 1, pour, lors de l'échantillonnage, limiter le repliement des fréquences,
- échantillonner et numériser sur 12 à 14 bits, à la cadence Fe, le signal filtré, dans le dispositif 2,
- filtrer la suite d'échantillons numérisés $S_{n+2}$, dans le filtre numérique 3, pour augmenter le rapport signal sur bruit et diminuer la cadence de calcul de a, $\frac{Fe}{N}$, par rapport à la cadence d'échantillonnage Fe,
- combiner, dans l'unité de calcul, les valeurs $s_{n+2}$, $s_{n+1}$, $s_n$ fournies par le filtre 3, pour calculer, aux instants i Te, avec i = (n+2), les suites discrètes
  . $x_i$,
  . $y_i$,

. la valeur cumulée XM de $x_i$,

$$XM = \sum_{i=1}^{N} x_i,$$

. la valeur cumulée YM de $y_i$,

$$YM = \sum_{i=1}^{N} y_i,$$

. la valeur cumulée $C_{xx}$ de $x_i^2$,

$$C_{xx} = \sum_{i=1}^{N} x_i^2,$$

- calculer tous les N cycles, dans l'unité de calcul 5,
  . la valeur centrée

$$C'_{xy_K}$$

de $C_{xy}$,

$$C'_{xy_K} = C_{xy} - \frac{XM \cdot YM}{N}$$

. la valeur centrée

$$C'_{xx_K}$$

de $C_{xx}$,

$$C'_{xx_K} = C_{xx} - \frac{XM^2}{N}$$

. la valeur de $\hat{\alpha}_K$, rapport des deux valeurs centrées,

$$\hat{a}_K = \frac{C'_{xy_K}}{C'_{xx_K}}$$

K étant l'indice de l'intervalle de durée N Te, indiquant que la cadence des calculs de l'unité 5 est $\frac{Fe}{N}$, c'est-

13

à-dire finalement estimer le coefficient, qui contient l'information fréquence du signal échantillonné, de la régression linéaire, à un seul coefficient, par les moindres carrés, de la relation linéaire entre des échantillons numérisés successifs,

- réinitialiser à zéro, depuis la portion 5' de l'unité 5, les valeurs calculées dans l'unité 4.

L'unité de calcul 5 fournissant, tous les N cycles, la valeur de $\widehat{\alpha}_K$, cette valeur est filtrée dans le filtre numérique passe-bas de lissage, du premier ordre, 8 fournissant la valeur de $\widehat{\alpha}_K^{\Xi}$ multipliée par $\lambda$ dans l'unité 9 qui fournit au filtre numérique 3 la valeur de ($\lambda\widehat{\alpha}_K^{\Xi}$). L'équation du filtre est

$$\hat{a}_K^{\Xi} = k_1 \hat{a}_{K-1}^{\Xi} + k_2 (\hat{a}_K + \hat{a}_{K-1})$$

avec

$$k_1 = \frac{W - 1}{W + 1}, \quad k_2 = \frac{1}{W + 1}$$

$$W = \frac{1}{tg \left( \pi \dfrac{Fc}{\frac{Fe}{N}} \right)}$$

La cadence de calcul de $\widehat{\alpha}_K$ étant $\frac{Fe}{N}$ il peut être intéressant de calculer la fréquence $F_x$ à une cadence plus faible et donc de sous-échantillonner.

Avant de procéder à ce sous-échantillonnage, en ne conservant qu'une mesure sur L, il est encore préférable de filtrer les valeurs de $\widehat{\alpha}_K$, dans le filtre de l'unité 6 de filtrage et de sous-échantillonnage.

Le filtrage le plus simple consiste à déterminer la valeur moyenne sur L mesures, selon la fonction

$$\hat{a}_{\frac{K}{L}} = \frac{1}{L} \sum_{K=1}^{L} \hat{a}_{K+L}$$

la valeur

$$\hat{a}_{\frac{K}{L}}$$

étant donc fournie tous les N•L cycles.

On pourrait aussi utiliser un filtre passe-bas plus performant, d'ordre de 2 à 4, de fonction générale

$$\hat{a}_K^{\Xi} = \sum_{i=o}^{I} b_i \hat{a}_{K-i}^{\Xi} + \sum_{j=o}^{J} c_j \hat{a}_{K-j}$$

mais d'une plus grande complexité de réalisation, $b_i$ et $c_j$ étant les paramètres définissant le filtre.

La fréquence $F_x$ est ensuite déterminée dans l'unité de calcul 7. On a vu plus haut que l'information fréquence $F_x$ était contenue dans a selon la relation

$$F_x = \frac{Fe}{2\pi} \text{ arc cos } \frac{a}{2}$$

Si $0 < Fe < 2Fx$, Fx est donnée par la relation

$$Fx = \frac{Fe}{\pi} \text{ arc cos } \frac{a}{2} + M\,Fe$$

M étant un entier positif.
En conséquence, on peut écrire, pour l'estimée $\widehat{F}_a$ de la fréquence apparente,

$$\widehat{F}_a = \frac{Fe}{2\pi} \text{ arc cos } \frac{\frac{\widehat{a}}{K}}{\frac{L}{2}}$$

et

$$\widehat{F}_x = \widehat{F}_a + M\,Fe$$

L'information "fréquence" est fournie en sortie de l'unité 7, en l'occurrence sur 32 bits.

Posons que la fréquence d'échantillonage optimale $Fe^{=}$ est égale à $\widehat{F}_x$ ($\widehat{F}_x$ étant l'estimée de la fréquence du signal d'entrée) ; la valeur de M détermine celle de $\alpha$ .

En effet, pour obtenir une bonne précision de calcul, on choisit la fréquence Fe telle que

$$F_a = \frac{Fe}{4}$$

pour que, ainsi,

$$\cos \frac{2\pi F_a}{F_e},$$

tel que

$$\cos \frac{2\pi F_a}{F_e} \qquad \frac{a}{2}$$

soit nul, ou très petit par rapport à 1. Alors, d'où $Fe = \alpha F_x$

$$F_a = F_x - M F_e$$
$$\neq \frac{F_e}{4}$$

$$\alpha = \frac{4}{4M + 1}$$

Pour
M = 1, on a $\alpha = \frac{4}{5}$
M = 2, on a $\alpha = \frac{4}{9}$
M = 3, on a $\alpha = \frac{4}{13}$
La fonction du filtre 3 est

$$s_{n+2} = (\lambda a_K^{\Xi})s_{n+1} - \lambda^2 s_n + \gamma S_{n+2}$$

La valeur de $\lambda$ fixe la largeur à -3dB du filtre 3, qui doit être supérieure ou égale à la bande passante des variations de la fréquence $F_x$.

Dans une forme de réalisation effective, il a été adopté

$$\lambda = 1 - \tfrac{1}{64},$$

soit

$$\lambda^2 \neq 1 - \tfrac{1}{32}.$$

Ce choix permet de satisfaire l'égalité approximative

$$\Delta f_c \simeq 2 \text{ Hz},$$

car, et en référence à l'ouvrage "Traitement numérique du signal, M. Bellanger, Editions Masson, 1984 ", on a

$$\Delta f_c \sim \frac{\hat{F}_a}{Q}$$

avec

$$Q \simeq \frac{1}{(1-\lambda^2)\sqrt{1-\frac{a^2}{2}}}$$

Si $Fe = \tfrac{4}{9} F_x$, on a alors $\hat{F}_a \simeq \tfrac{Fe}{4}$, d'où $\hat{\alpha} \simeq 0$.

On peut ensuite facilement démontrer la relation

$$\Delta f_c \simeq \frac{\hat{F}_a}{32}$$

Si $\hat{F}_a$ est supérieure sensiblement à $\tfrac{90}{4}$, alors $\Delta f_c$ est supérieure sensiblement à 3 Hz

La bande passante maximale de $\hat{\alpha}_K$, ou celle des variations de $F_x$, est égale à $\tfrac{Fe}{2N}$, N étant le nombre de valeurs sur lesquelles l'unité 4 effectue ses calculs.

Pour que le repliement des fréquences reste faible, il faut que la bande passant

$$\frac{\Delta f_c}{2}$$

16

reste inférieure à la bande passante

$$\frac{Fe}{2N} \gg \frac{F_a}{2Q}$$

Dans le cas où $F_a$ est peu différente de $\frac{Fe}{4}$ , on doit avoir, pour satisfaire cette inégalité

$N \le Q$.

On prend $N \simeq Q$, d'où $N = 32$.

Abordons maintenant le choix du facteur $\alpha$. Lorsque la capacité de calcul le permet, cas non envisagé ci-dessus, on peut choisir $\alpha$ très grand par rapport à 1 et au moins égal à 2,5. Le filtre 1 peut alors être un simple filtre passe-bas, d'ordre assez élevé pour que les effets de repliement des fréquences soient faibles.

En l'espèce, il a été choisi pour $\alpha$ une valeur inférieure à 1, correspondant effectivement, quant au filtre 1, à un filtre passe-bande de largeur $\Delta f$ inférieure à Fe, conformément au théorème de Shannon.

Plus précisément, et pour $\Delta f \simeq 160$ Hz, M étant donnée et déterminant $\alpha$, Fe est choisie par les relations

$Fe = \alpha \hat{F}_x$ , pour $1000$ Hz $< \hat{F}_x < 1500$ Hz
$Fe = \frac{\alpha}{2} \hat{F}_x$, pour $1500$ Hz $\le \hat{F}_x < 3000$ Hz.

Lors de l'initialisation, abordée plus loin, ou d'un changement de Fe, on choisit $\alpha$ le plus voisin possible de $\frac{4}{5}$ , si la capacité de calcul le permet. Pour réduire les cadences de calcul, on peut prendre $\alpha$ très voisin de $\frac{4}{9}$ .

Pour des fréquences $\hat{F}_x$ inférieures à 1000 Hz, Fe pourra être quand même déterminée comme si $\hat{F}_x$ était pratiquement égale à 1000 Hz; la valeur de Fe n'est modifiée que si le rapport

$$\frac{\hat{F}_a}{Fe}$$

n'est pas compris dans l'intervalle

$[0,05 - 0,47]$ .

On a vu que la valeur de $\hat{\alpha}_K$ était fournie par l'unité de calcul 5 à une cadence $\frac{Fe}{N}$ . Mais comme Fe dépend de $F_x$, $\hat{\alpha}_K$ n'est donc pas fournie à une cadence fixe. Cela peut être un inconvénient. En conséquence, et pour disposer de la valeur de $\hat{\alpha}_K$ quand même à une cadence fixe, sous-multiple ou voisine de $\frac{Fe}{N}$ par exemple, on peut utiliser un filtre interpolateur ou extrapolateur, tel qu'enseigné par les ouvrages "Systèmes et asservissements linéaires échantillonnés" et "Traitement numérique du signal", déjà évoqués ci-dessus.

Une autre méthode, plus simple, consiste à choisir une fréquence d'échantillonnage Fe qui satisfasse simultanément aux conditions suivantes :
pour $F_S$, fréquence fixe prédéterminée, par exemple égale à 25 Hz,
pour $1000$ Hz $< \hat{F}_x < 1500$ Hz

$$\begin{cases} Fe \approx \alpha \hat{F}_x \\ Fe = k_1 \cdot F_S \end{cases}$$

avec $k_1$ entier positif,
pour $1500$ Hz $< \hat{F}_x < 3000$ Hz

$$\begin{cases} Fe \approx \dfrac{\alpha}{2} \; \hat{F}_x \\ Fe = k_2 \; F_S \end{cases}$$

avec $k_2$ entier positif.

L'information fréquence $\hat{F}_x$ fournie par l'unité de calcul 7 est envoyée sur l'unité 10 de calcul des fréquences optimales Fe et $Fe_{Fcc}$ conformément aux relations déjà évoquées

$$\begin{cases} Fe = \alpha \; \hat{F}_x \quad ou \quad Fe = \dfrac{\alpha}{2} \; \hat{F}_x \; , \\ Fe_{Fcc} = \beta \; fo \\ \beta = \dfrac{\pi}{2} \; \dfrac{C}{C_1} \end{cases}$$

Si $\beta = 40$, comme évoqué plus haut, on peut écrire

$Fe_{Fcc} = 40 \; \hat{F}_x.$

L'unité de calcul 10 commande l'unité 11 de surveillance de Fe et $Fe_{Fcc}$, qui détermine la partie entière N′ de

$$\frac{F_Q}{Fe} ,$$

ici sur 12 bits, et la partie entière N″ de

$$\frac{F_Q}{2Fe_{Fcc}} ,$$

ici sur 8 bits.

N′ et N″ alimentent respectivement les deux diviseurs programmables 14, 15, connectés à la sortie de l'horloge de référence 13 délivrant une fréquence $F_H$.

L'horloge 13 est une horloge pilotée par quartz du type PMT P5 ou PMT U515 de la Compagnie d'Electronique et de piezoélectricité (CEPE).

Le diviseur programmable 14, en référence à la figure 7, comporte deux registres 200 en parallèle recevant, sur une entrée 201, un ordre de chargement, et sur une autre entrée 202, les données N′ d'un bus 203, et alimentant trois compteurs 204 en cascade, recevant, par l'intermédiaire d'un diviseur 205, ici par 2, le signal $F_H$ de l'horloge 13, et fournissant

$$Fe = \frac{F_H}{N'} .$$

Le diviseur programmable 15, en référence à la figure 8, comporte un registre 300 recevant, sur son entrée 301, un ordre de chargement, et, sur son entrée 302, les données N″ d'un bus 303, et alimentant deux compteurs 304 en cascade, recevant, par l'intermédiaire d'un diviseur 305, ici par 2, le signal de l'horloge 13, et fournissant

$$Fe_{Fcc.} = \frac{F_H}{2N''}$$

A titre d'exemple, et pour considérer la réalisation effective, on a

$$\begin{cases} F_H \approx 10 \text{ MHz} \\ 41 \leqslant N'' \leqslant 128 \\ 3571 \leqslant N' \leqslant 14286 \end{cases}$$

Les unités 3 à 11 décrites ci-dessus sont regroupées dans un processeur ou calculateur du commerce, par exemple du type Alpha 732 de la Demanderesse ou 9900 de la Société Texas Instruments.

Le fréquencemètre qui vient d'être décrit fonctionne soit en régime normal, soit en régime d'initialisation. Ce régime d'initialisation résulte soit de la mise sous tension, soit d'un ordre de réinitialisation, c'est-à-dire de remise à zéro, consécutif, par exemple, à une variation de fréquence en échelon supérieure à la bande passante à -10dB environ du filtre numérique 3.

L'initialisation implique le choix de la fréquence de commutation $Fe_{Fcc}$, qui détermine la fréquence centrale fo du filtre analogique 1, selon la relation fo $= \frac{1}{\beta} Fe_{Fcc}$, ainsi que le choix de la fréquence Fe d'échantillonnage du signal.

Si la fréquence est connue, pour un capteur, avec une précision de l'ordre de un pour cent, sa valeur est introduite dans le fréquencemètre par tout moyen approprié, du genre clavier numérique par exemple.

Si la fréquence n'est pas connue, tout du moins avec cette précision, deux situations peuvent surgir.

Si le filtre analogique anti-repliement 1 ne comporte en fait qu'un seul des deux filtres passe-bas du second ordre 103, 105 (figure 3), de fréquence de coupure $F_{ce}$, on choisit

$$\begin{cases} Fe \approx 2,5 \ F_{ce} \\ \lambda = 0 \end{cases}$$

$\hat{\alpha}_K$ et $\hat{F}_x$ sont calculées sur quelques secondes, et la valeur moyenne de $\hat{F}_x$ sur quelques secondes est adoptée comme valeur initiale de $F_x$, permettant de calculer les valeurs initiales de Fe et $Fe_{Fcc}$. Au cours d'une seconde phase d'initialisation de quelques secondes, avec $\lambda$ non nulle, on confirme les valeurs initiales précédentes.

Si le filtre analogique anti-repliement 1 comporte au moins un des filtres à commutation de capacités 102, 104 et un des filtres passe-bas 103, 105, c'est-à-dire si le rapport signal sur bruit n'est pas suffisant, alors on déplace la fréquence centrale fo du filtre à commutation de capacités dans tout le domaine $D_F$ des fréquences à mesurer, le nombre de valeurs à prendre en compte pour le diviseur programmable 15 étant égal à la partie entière du rapport

$$\frac{D_F}{B_{Fcc}} \ ,$$

$B_{Fcc}$ étant la largeur à -3dB du filtre 1. La valeur centrale du filtre, à chaque valeur différente prise en compte dans le diviseur programmable, est distante de $B_{Fcc}$ de la précédente. Pour chacune de ces valeurs, on calcule $C'_{xx}$, avec nulle et Fe égale à 2,5 à 3 $F_{ce}$. On adopte pour valeur initiale, pour le diviseur 15 celle qui correspond au maximum de $C_{xx}$. Comme dans le cas précédent, on dispose ensuite de la

valeur initiale de $\widehat{F}_x$, permettant de calculer N′ et N″, des diviseurs programmables 14, 15.

Le processus d'initialisation est mis en oeuvre dans l'unité 16 commandant l'unité de calcul 10.

Les valeurs de $Fe_{Fcc}$ et Fe sont surveillées et éventuellement ajustées pour avoir

$$0,05 \le \tfrac{Fa}{Fe} \le 0,47$$
$$|\, F_x - fo \,| \le \tfrac{\Delta f}{2} \, .$$

**Revendications**

1. Procédé de mesure de la fréquence $F_x$ d'un signal périodique S(t) de la forme $A \sin 2\pi F_x t + B(t)$, où B-(t) est le bruit, dans lequel :
   - on filtre (1) le signal S(t),
   - on échantillonne (2), à une cadence $Fe = \tfrac{1}{Te}$, le signal S(t), filtré avant l'échantillonnage pour limiter le repliement des fréquences, et on numérise les échantillons,
   - on filtre, dans un filtre passe-bande (3) à bande étroite, les échantillons numérisés, pour augmenter le rapport signal sur bruit,
   - on procède (3,4) à une régression linéaire, à un seul coefficient a, par la méthode des moindres carrés, d'une relation linéaire, entre des échantillons numérisés successifs, de la forme

   $$s_{n+2} + s_n = a\, s_{n+1}$$

   avec

   $$a = 2 \cos 2\pi F\, Te,$$

   $s_n$ étant l'échantillon filtré de l'instant $nTe$,
   on calcule, sur un horizon temporel d'estimation $NTe$ et donc à une cadence $\tfrac{Fe}{N}$, N étant un entier positif, l'estimation $\widehat{\alpha}$ du coefficient a, de laquelle on tire $F_X$(7,8) selon $F_x = \tfrac{Fe}{2\pi} \arccos \tfrac{a}{2}$, et on asservit (8,9) la fréquence centrale du filtre passe-bande (3) sur la fréquence estimée du signal échantillonné et numérisé.

2. Procédé selon la revendication 1, dans lequel, quand on échantillonne (2) à une cadence Fe inférieure à la fréquence $F_x$ à mesurer, avant échantillonnage, on filtre (1) le signal S(t) dans un filtre passe-bande dont on asservit (8,9) la fréquence centrale sur la fréquence à mesurer.

3. Procédé selon la revendication 1, dans lequel, quand on échantillonne (2) à une cadence Fe supérieure à la fréquence $F_x$ à mesurer, avant échantillonnage, on filtre (1) le signal S(t) dans un filtre passe-bas.

4. Procédé selon l'une des revendications 1 à 3, dans lequel on procède à ladite régression linéaire autour de la valeur moyenne des variables qu'on estime sur l'horizon temporel $NTe$.

5. Procédé selon l'une des revendications 1 à 4, dans lequel on filtre (1) les échantillons du signal dans un filtre passe-bande de fonction

   $$s_{n+2} = (\lambda\widehat{\alpha}^{\approx})s_{n+1} - \lambda^2 s_n + \gamma S_{n+2}$$

   dans laquelle :
   $\lambda$  est une constante représentative de l'amortissement et de la largeur du filtre à -3dB,
   $\widehat{\alpha}^{\approx}$  est la valeur de l'estimée du coefficient a filtrée par un filtre passe-bas, pour lisser la valeur du paramètre fixant le centre du filtre passe-bande,
   $\gamma$  est une constante de cadrage fixant le gain statique du filtre passe-bande,
   $S_{n+2}$  est l'échantillon non filtré de l'instant $(n+2)Te$,
   $s_n$  est l'échantillon filtré de l'instant $n\, Te$.

6. Procédé selon l'une des revendications 1 à 5, dans lequel on sous-échantillonne (6) et on détermine (7) la fréquence $F_X$ à une cadence plus faible que pour le coefficient a.

**7.** Procédé selon l'une des revendications 1 à 6, dans lequel, pour déterminer la valeur du coefficient a à une cadence fixe, on désynchronise la cadence de calcul du coefficient a à une fréquence prédéterminée par un filtre interpolateur ou extrapolateur.

**8.** Procédé selon l'une des revendications 1 à 7, dans lequel, quand la fréquence d'échantillonnage Fe est inférieure au double de la fréquence à mesurer $F_x$, on détermine (7) celle-ci en ajoutant à la valeur calculée de la fréquence apparente Fa le produit de la valeur de la fréquence d'échantillonnage Fe et d'un nombre entier M.

**9.** Procédé selon l'une des revendications 1 à 8, dans lequel, pour initialiser (16) le procédé, on calcule les estimées du coefficient a et de la fréquence à mesurer $F_X$ sur quelques secondes et on adopte la valeur moyenne de l'estimée de la fréquence $F_X$ comme valeur initiale.

**10.** Fréquencemètre pour la mise en oeuvre du procédé selon l'une des revendications 1 à 9, caractérisé par le fait qu'il comporte, en série, un filtre analogique anti-repliement (1), un dispositif (2) d'échantillonnage et de conversion analogique-numérique, un filtre passe-bande numérique asservi (3) et une unité de calcul (4-7) agencée pour procéder à une régression linéaire, à un seul coefficient a, de la relation linéaire entre des échantillons numérisés successifs fournis par le dispositif d'échantillonnage et de conversion, et calculer l'estimation du coefficient a de laquelle est tirée la fréquence à mesurer, la fréquence centrale du filtre passe-bande numérique (3) étant asservie sur la fréquence estimée du signal du dispositif d'échantillonnage et de conversion (2).

**11.** Fréquencemètre selon la revendication 10, dans lequel le filtre analogique anti-repliement (1) comporte au moins un filtre passe-bande à commutation de capacités (102,104), recevant un signal de commutation d'un premier diviseur programmable (15) relié à la sortie d'une horloge de référence (13) et commandé par l'unité de calcul (4-7).

**12.** Fréquencemètre selon la revendication 11, dans lequel le filtre analogique anti-repliement (1) comporte de plus au moins un filtre passe-bas de lissage (103,105).

**13.** Fréquencemètre selon l'une des revendications 10 à 12, dans lequel le dispositif (2) d'échantillonnage et de conversion reçoit un signal d'échantillonnage d'un second diviseur programmable (14) relié à la sortie de l'horloge de référence (13) et commandé par l'unité de calcul (4-7).

**14.** Fréquencemètre selon la revendication 13, dans lequel l'unité de calcul (4-7) commande les diviseurs programmables (15,14) par l'intermédiaire d'un module (10) de calcul des fréquences de commutation et d'échantillonnage et d'une unité (11) de surveillance de ces fréquences.

**15.** Fréquencemètre selon la revendication 14, dans lequel une unité d'initialisation (16) est reliée à l'entrée du module (10) de calcul des fréquences de commutation et d'échantillonnage.

**16.** Fréquencemètre selon l'une des revendications 10 à 15, dans lequel le filtre numérique asservi (3) est contrôlé par l'unité de calcul (4-7) par l'intermédiaire d'un filtre passe-bas numérique (8).

**Claims**

**1.** Process for measuring the frequency Fx of a periodic signal S(t) of the form A sin $2\pi$ $F_x$t + B(t), where B(t) is the noise, in which:
  - the signal S(t) is filtered (1),
  - the signal S(t) is sampled (2) at a rate Fe = 1/Te, the signal having been filtered before sampling in order to limit the aliasing of the frequencies, and the samples are digitized,
  - the digitized samples are filtered in a narrow-band band-pass filter (3) so as to increase the signal-to-noise ratio,
  - a linear regression, with a single coefficient a, is carried out (3,4) by the method of least squares, of a linear relation, between successive digitized samples, of the form

$$s_{n+2} + s_n = a\, s_{n+1}$$

with

$$a = 2 \cos 2\pi F \, Te,$$

$s_n$ being the filtered sample from the instant $nTe$, the estimation $\hat{a}$ of the coefficient $a$ is calculated, over an estimation time horizon $NTe$ and hence at a rate $Fe/N$, $N$ being a positive integer, and from which estimation $F_x$ is derived (7,8) according to

$$F_x = (Fe/2\pi) \arccos (a/2)$$

and the central frequency of the band-pass filter (3) is locked (8,9) onto the estimated frequency of the sampled and digitized signal.

2. Process according to claim 1, in which, when sampling (2) at a rate $Fe$ below the frequency $F_x$ to be measured, before sampling, the signal $S(t)$ is filtered (1) in a band-pass filter whose central frequency is locked (8,9) onto the frequency to be measured.

3. Process according to claim 1, in which, when sampling (2) at a rate $Fe$ above the frequency $F_x$ to be measured, before sampling, the signal $S(t)$ is filtered (1) in a low-pass filter.

4. Process according to one of claims 1 to 3, in which the said linear regression is carried out around the mean value of the variables which is estimated over the time horizon $NTe$.

5. Process according to one of claims 1 to 4, in which the samples of the signal are filtered (1) in a band-pass filter with function

$$s_{n+2} = (\lambda \hat{\alpha}^{\phi}) s_{n+1} - \lambda^2 s_n + \gamma s_{n+2}$$

in which

- $\lambda$  is a constant representing the damping and the width of the filter at -3dB,
- $\hat{\alpha}^{\phi}$  is the value of the estimate of the coefficient $a$ filtered by a low-pass filter, in order to smooth the value of the parameter fixing the centre of the band-pass filter,
- $\gamma$  is a scaling constant fixing the static gain of the band-pass filter,
- $s_{n+2}$  is the unfiltered sample from the instant $(n+2)Te$,
- $s_n$  is the filtered sample from the instant $n \, Te$.

6. Process according to one of claims 1 to 5, in which a sub-sampling takes place (6) and the frequency $F_x$ is determined (7) at a rate lower than for the coefficient $a$.

7. Process according to one of claims 1 to 6, in which, in order to determine the value of the coefficient $a$ at a fixed rate, the rate of calculating the coefficient $a$ is desynchronized with a frequency predetermined by an interpolator or extrapolator filter.

8. Process according to one of claims 1 to 7, in which, when the sampling frequency $Fe$ is less than twice the frequency to be measured $F_x$, the latter is determined (7) by adding to the calculated value of the apparent frequency $fa$ the product of the value of the sampling frequency $Fe$ and an integer $M$.

9. Process according to one of claims 1 to 8, in which, in order to initialize (16) the process, the estimates of the coefficient $a$ and of the frequency to be measured $F_x$ are calculated over a few seconds and the mean value of the estimate of the frequency $F_x$ is adopted as initial value.

10. Frequency meter for the implementation of the process according to one of claims 1 to 9, characterized in that it includes, in series, an anti-aliasing analog filter (1), a device (2) for sampling and for analog/digital conversion, a locked digital band-pass filter (3) and a calculating unit (4-7) configured to carry out a linear regression, with a single coefficient $a$, of the linear relation between successive digitized samples provided by the sampling and conversion device, and to calculate the estimation of the coefficient $a$ from which the frequency to be measured is derived, the central frequency of the digital band-pass filter (3) being locked onto the estimated frequency of the signal from the sampling and conversion device (2).

**11.** Frequency meter according to claim 10, in which the anti-aliasing analog filter (1) includes at least one switched capacitance band-pass filter (102,104), receiving a switching signal from a first programmable divider (15) connected to the output of a reference clock (13) and controlled by the calculating unit (4-7).

**12.** Frequency meter according to claim 11, in which the anti-aliasing analog filter (1) moreover includes at least one low-pass smoothing filter (103,105)

**13.** Frequency meter according to one of claims 10 to 12, in which the sampling and conversion device (2) receives a sampling signal from a second programmable divider (14) connected to the output of the reference clock (13) and controlled by the calculating unit (4-7).

**14.** Frequency meter according to claim 13,in which the calculating unit (4-7) controls the programmable dividers (15,14) by way of a module (10) for calculating the switching and sampling frequencies and of a unit (11) for monitoring these frequencies.

**15.** Frequency meter according to claim 14, in which an initializing unit (16) is connected to the input of the module (10) for calculating the switching and sampling frequencies.

**16.** Frequency meter according to one of claims 10 to 15, in which the locked digital filter (3) is controlled by the calculating unit (4-7) by way of a digital low-pass filter (8).

## Patentansprüche

**1.** Verfahren zur Messung der Frequenz $F_x$ eines periodischen Signals S(t) der Form A sin $2\pi F_x t$ + B(t), wobei B(t) das Rauschen ist, bei dem
   - man das Signal S(t) filtert (1),
   - man mit einer Abtastfrequenz Fe = 1/Te das Signal S(t) abtastet (2), das vor der Abtastung gefiltert wird, um die Rückfaltung von Frequenzen zu begrenzen und man die Abtastproben digitalisiert;
   - man die digitalisierten Abtastproben in einem Bandfilter (3) mit enger Bandbreite filtert, um das Signal-Rausch-Verhältnis zu erhöhen,
   - man (3, 4) mittels der Methode der kleinsten Quadrate mit einem einzigen Koeffizienten a eine lineare Regression einer linearen Beziehung zwischen aufeinanderfolgenden digitalisierten Abtastproben der Form

$$s_{n+2} + s_n = a \, s_{n+1}$$

mit

$$a = 2 \cos 2\pi F \, Te,$$

durchführt, wobei $s_n$ die gefilterte Abtastprobe des Zeitpunkts nTe ist,
man mittels einer Zeitbasisabschätzung NTe und folglich mit einer Abtastfrequenz Fe/N, mit N als einer positiven ganzen Zahl, den Schätzwert $\hat{a}$ des Koeffizienten a berechnet, aus dem man gemäß

$$F_x = (Fe/2\pi) \, arc \, cos \, (a/2)$$

$F_x$ ableitet (7, 8), und
man (8, 9) die Bandmittenfrequenz des Bandfilters (3) auf die geschätzte Frequenz des abgetasteten und digitalisierten Signals regelt.

**2.** Verfahren nach Anspruch 1, bei dem man, wenn man mit einer Abtastfrequenz Fe abtastet (2), die kleiner ist als die zu messende Frequenz $F_x$, vor der Abtastung das Signal S(t) in einem Bandfilter filtert (1), dessen Bandmittenfrequenz man auf die zu messende Frequenz regelt (8, 9).

3.  Verfahren nach Anspruch 1, bei dem man, wenn man mit einer Abtastfrequenz Fe abtastet (2), die größer ist als die zu messende Frequenz $F_x$, vor der Abtastung das Signal S(t) in einem Tiefpaßfilter filtert (1).

4.  Verfahren nach einem der Ansprüche 1 bis 3, bei dem man die oben erwähnte lineare Regression um den Mittelwert der Variablen, die man mit dem Zeitbasiswert NTe abschätzt, vornimmt.

5.  Verfahren nach einem der Ansprüche 1 bis 4, bei dem man die Abtastproben des Signals in einem Bandfilter der Funktion

$$s_{n+2} = (\lambda \widehat{\alpha^\phi})s_{n+1} - \lambda^2 s_n + \gamma s_{n+2}$$

filtert (1), wobei:

$\lambda$ eine Konstante ist, welche die Dämpfung und die Breite des Filters bei -3dB repräsentiert,

$\widehat{\alpha^\phi}$ der Schätzwert des Koeffizienten a ist, gefiltert mittels eines Tiefpaßfilters, um den Wert des Parameters zu glätten, der die Mitte des Bandfilters bestimmt,

$\gamma$ eine Einstellkonstante ist, welche die statische Verstärkung des Bandfilters bestimmt,

$s_{n+2}$ die nicht gefilterte Abtastprobe des Zeitpunkts (n + 2) Te ist,

$s_n$ die gefilterte Abtastprobe des Zeitpunkts n Te ist.

6.  Verfahren nach einem der Ansprüche 1 bis 5, bei dem man die Frequenz $F_x$ mit einer Abtastfrequenz, die geringer ist als für den Koeffizienten a, überabtastet (6) und bestimmt (7).

7.  Verfahren nach einem der Ansprüche 1 bis 6, bei dem man, um den Wert des Koeffizienten a bei einer festen Abtastfrequenz zu bestimmen, die Abtastfrequenz der Berechnung des Koeffizienten a bei einer Frequenz, die durch ein Interpolations- oder Extrapolationsfilter vorbestimmt ist, desynchronisiert.

8.  Verfahren nach einem der Ansprüche 1 bis 7, bei dem man, wenn die Abtastfrequenz Fe kleiner ist als das Zweifache der zu messenden Frequenz $F_x$, diese bestimmt (7), indem man dem errechneten Wert der virtuellen Frequenz Fa das Produkt aus dem Wert der Abtastfrequenz Fe und einer ganzen Zahl M hinzufügt.

9.  Verfahren nach einem der Ansprüche 1 bis 8, bei dem man zur Initialisierung (16) des Verfahrens die Schätzwerte des Koeffizienten a und der zu messenden Frequenz $F_x$ über einige Sekunden berechnet und man den Mittelwert der Schätzung der Frequenz $F_x$ als Anfangswert übernimmt.

10. Frequenzmeßgerät zur Durchführung des erfindungsgemäßen Verfahrens nach einem der Ansprüche 1 bis 9, dadurch gekennzeichnet, daß es in Serie enthält: einen analogen Anti-Rückfaltungs-Filter (1), eine Vorrichtung (2) zur Abtastung und Analog-Digital-Umsetzung, einen digitalen geregelten Bandfilter (3) und eine Recheneinheit (4-7), dafür vorgesehen, mit einem einzigen Koeffizienten a eine lineare Regression der linearen Beziehung zwischen den von der Einrichtung zur Abtastung und Umsetzung gelieferten aufeinanderfolgenden digitalisierten Abtastproben vorzunehmen und den Schätzwert des Koeffizienten a zu berechnen, aus dem die zu messende Frequenz abgeleitet wird, wobei die Bandmittenfrequenz des digitalen Bandfilters (3) auf die geschätzte Frequenz des Signals der Vorrichtung zur Abtastung und Umsetzung (2) geregelt wird.

11. Frequenzmeßgerät nach Anspruch 10, bei dem der analoge Anti-Rückfaltungs-Filter (1) mindestens einen Schalter-Kondensator-Bandfilter (102, 104) enthält, der ein Schaltsignal eines ersten programmierbaren Teilers (15) empfängt, der mit dem Ausgang eines Referenztaktgebers (13) verbunden ist und von der Recheneinheit (4-7) gesteuert wird.

12. Frequenzmeßgerät nach Anspruch 11, bei dem der analoge Anti-Rückfaltungs-Filter (1) zusätzlich mindestens einen Tiefpaßfilter zur Glättung (103, 105) enthält.

13. Frequenzmeßgerät nach einem der Ansprüche 10 bis 12, bei dem die Vorrichtung (2) zur Abtastung und Umsetzung ein Abtastsignal eines zweiten programmierbaren Teilers (14) empfängt, der mit dem Ausgang des Referenztaktgebers (13) verbunden ist und von der Recheneinheit (4-7) gesteuert ist.

**14.** Frequenzmeßgerät nach Anspruch 13, bei dem die Recheneinheit (4-7) die programmierbaren Teiler (15, 14) mittels eines Moduls (10) zur Berechnung der Schaltfrequenz und der Abtastfrequenz und einer Einheit (11) für die Überwachung dieser Frequenzen steuert.

**15.** Frequenzmeßgerät nach Anspruch 14, bei dem eine Initialisierungseinheit (16) mit dem Eingang des Moduls (10) zur Berechnung der Schaltfrequenz und der Abtastfrequenz verbunden ist.

**16.** Frequenzmeßgerät nach einem der Ansprüche 10 bis 15, bei dem der digitale geregelte Filter (3) durch die Recheneinheit (4-7) mittels eines digitalen Tiefpaßfilters (8) geregelt ist.

EP 0 309 336 B1

FIG. 1

FIG.2

FIG.3

FIG.4

FIG.5

FIG. 6

FIG. 7

FIG. 8